(19) Europäisches Patentamt
European Patent Office
Office européen des brevets

(11) **EP 2 337 221 A1**

(12) **DEMANDE DE BREVET EUROPEEN**

(43) Date de publication:
**22.06.2011 Bulletin 2011/25**

(51) Int Cl.:
*H03H 9/02* (2006.01)       *G04B 17/06* (2006.01)
*G04B 17/22* (2006.01)

(21) Numéro de dépôt: **09179323.2**

(22) Date de dépôt: **15.12.2009**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA RS**

(71) Demandeur: **The Swatch Group Research and Development Ltd.**
**2074 Marin (CH)**

(72) Inventeurs:
• **Hessler, Thierry**
**2024 St-Aubin (CH)**

• **Conus, Thierry**
**2543 Lengnau (CH)**
• **Trümpy, Kaspar**
**4500 Soleures (CH)**

(74) Mandataire: **Couillard, Yann Luc Raymond et al**
**ICB**
**Ingénieurs Conseils en Brevets SA**
**Faubourg de l'Hôpital 3**
**2001 Neuchâtel (CH)**

(54) **Résonateur thermocompensé au moins aux premier et second ordres**

(57)     L'invention se rapporte à un résonateur (1) thermocompensé comportant un corps utilisé en déformation, l'âme (3) du corps comportant un premier matériau. Selon l'invention, le corps comporte au moins un premier et un deuxième revêtements (4, 5) permettant audit résonateur d'avoir des coefficients thermiques aux premier et deuxième ordres ($\alpha$, $\beta$) sensiblement nuls.

L'invention concerne le domaine des bases de temps et de fréquence.

Fig. 9

EP 2 337 221 A1

**Description**

Domaine de l'invention

L'invention se rapporte à un résonateur thermocompensé du type balancier-spiral, MEMS ou diapason permettant de fabriquer une base de temps ou de fréquence dont les coefficients thermiques sont sensiblement nuls au moins aux premier et deuxième ordres.

Arrière plan de l'invention

Le document EP 1 422 436 divulgue un spiral formé en silicium et recouvert de dioxyde de silicium afin de rendre le coefficient thermique sensiblement nul autour des températures de procédure COSC, c'est-à-dire entre +8 et +38°C. De même, le document WO 2008-043727 divulgue un résonateur MEMS qui possède des qualités similaires de faible dérive de son module d'Young dans la même plage de température.

Cependant la dérive de la fréquence même uniquement au deuxième ordre des divulgations ci-dessus peut nécessiter des corrections complexes selon les applications. Par exemple, pour que des montres électroniques puissent être certifiées COSC une correction électronique basée sur une mesure de la température doit être effectuée.

Résumé de l'invention

Le but de la présente invention est de pallier tout ou partie les inconvénients cités précédemment en proposant un résonateur compensé thermiquement au moins aux premier et deuxième ordres.

A cet effet, l'invention se rapporte à un résonateur thermocompensé comportant un corps utilisé en déformation, l'âme du corps comportant un premier matériau caractérisé en ce que le corps comporte au moins un premier et un deuxième revêtements permettant audit résonateur d'avoir des coefficients thermiques aux premier et deuxième ordres sensiblement nuls.

Avantageusement selon l'invention, le corps du résonateur utilisé en déformation comporte autant de revêtement que d'ordre du coefficient thermique à compenser. Ainsi, suivant les grandeurs et les signes de chaque ordre des matériaux de l'âme et de chaque revêtement, un calcul de chaque épaisseur est effectué afin de compenser chaque ordre.

Conformément à d'autres caractéristiques avantageuses de l'invention :

- le corps comporte un troisième revêtement permettant audit résonateur d'avoir des coefficients thermiques aux premier, deuxième et troisième ordres sensiblement nuls ;
- l'âme du corps comporte des coefficients thermoélastiques des premier et deuxième ordres qui sont négatifs comme du silicium monocristallin ;
- le corps comporte une section sensiblement en forme d'un quadrilatère dont les faces sont identiques deux à deux ou dont les faces sont entièrement revêtues ;
- le premier revêtement comporte des coefficients thermoélastiques du premier ordre positif et du deuxième ordre négatif comme du dioxyde de silicium ;
- le deuxième revêtement comporte un coefficient thermoélastique du deuxième ordre positif et du premier ordre positif comme du dioxyde de germanium ou comporte un coefficient thermoélastique du premier ordre négatif ;
- le premier revêtement est interverti avec le deuxième revêtement;
- le dépôt desdits revêtements est privilégié sur les faces parallèles par rapport au plan neutre du corps afin de modifier avec le plus d'intensité possible la fréquence dudit résonateur ;
- le corps est un barreau enroulé sur lui-même en formant un spiral et est couplé avec un volant d'inertie ou comporte au moins deux barreaux montés symétriquement afin de former un diapason ou est un résonateur MEMS.

Enfin, l'invention se rapporte également à une base de temps ou de fréquence, comme par exemple une pièce d'horlogerie, caractérisée en ce qu'elle comporte au moins un résonateur conforme à l'une des variantes précédentes.

Description sommaire des dessins

D'autres particularités et avantages ressortiront clairement de la description qui en est faite ci-après, à titre indicatif et nullement limitatif, en référence aux dessins annexés, dans lesquels :

- la figure 1 est une représentation générale en perspective d'un ressort-spiral ;
- la figure 2 est une section représentative du ressort-spiral de la figure 1 ;
- la figure 3 est une représentation de plusieurs modes de réalisation selon l'invention ;

- la figure 4 est un graphique représentant les modules élastiques de chaque matériau selon un premier mode de réalisation de l'invention ;
- la figure 5 est un graphique représentant les modules élastiques de chaque matériau selon un deuxième mode de réalisation de l'invention ;
- la figure 6 est un graphique représentant l'absence de variation de fréquence d'un résonateur selon l'invention ;
- la figure 7 est un graphique représentant la variation des premier et deuxième ordres du coefficient thermique d'un balancier-spiral de silicium enrobé de dioxyde de silicium ;
- la figure 8 est un graphique représentant la variation des premier et deuxième ordres du coefficient thermique d'un balancier-spiral de silicium enrobé de dioxyde de germanium ;
- la figure 9 est un graphique représentant la variation des premier et deuxième ordres du coefficient thermique d'un balancier-spiral de silicium enrobé de dioxyde de silicium et de dioxyde de germanium.

<u>Description détaillée des modes de réalisation préférés</u>

Comme expliqué ci-dessus, l'invention se rapporte à un résonateur qui peut être du type balancier-spiral, diapason ou plus généralement un résonateur du type MEMS (abréviation provenant des termes anglais « Micro Electro Mechanical System »). Afin d'apporter une explication plus simple de l'invention, seule l'application à un balancier-spiral est présentée ci-dessous. Cependant, d'autres applications de résonateur comme celles ci-dessus seront réalisables pour un homme du métier sans difficultés excessives à partir de l'enseignement ci-dessous.

De même, l'explication est portée sur une âme du corps, dans notre exemple un spiral, formé à partir de silicium monocristallin. Cependant, le matériau de l'âme n'est pas limité à du silicium monocristallin mais peut s'élargir à différents types de matériaux comme, par exemple, du polysilicium, du verre, du nitrure, du diamant, du quartz monocristallin ou du métal.

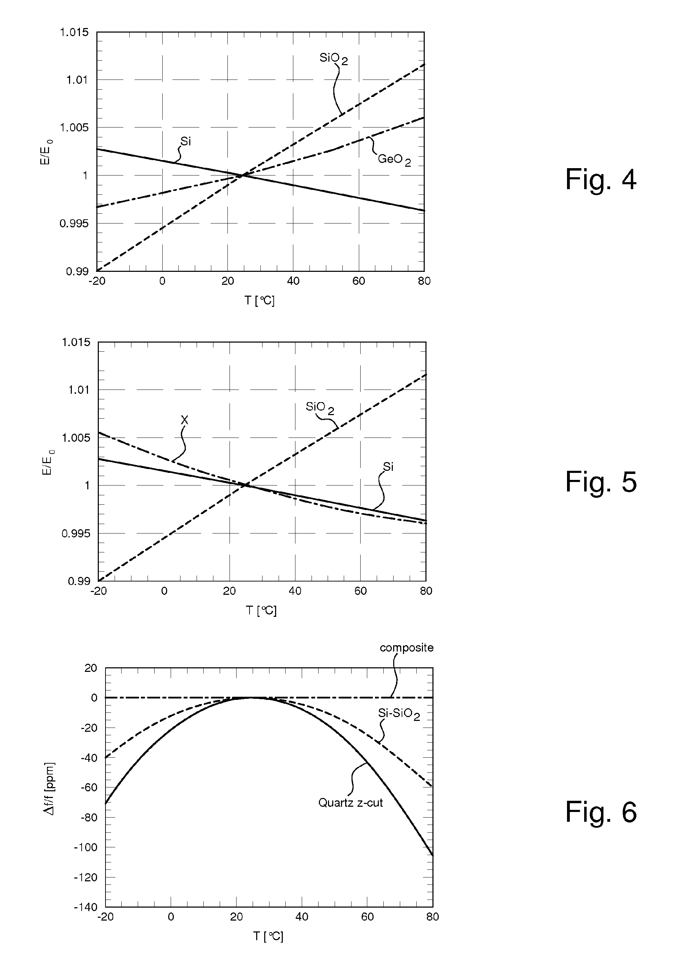

Dans le graphique à la figure 6, on peut voir la caractérisation de dérive de la fréquence pour des résonateurs actuels en fonction de la température. Une première courbe en trait plein intitulée « Quartz-z-cut » montre la dérive fréquentielle d'un diapason 32 kHz en quartz monocristallin réalisé dans une coupe z légèrement tournée. Une deuxième courbe en traits interrompus courts intitulé « Si-SiO$_2$ » montre la dérive fréquentielle d'un résonateur MEMS en silicium revêtu de dioxyde de silicium.

Pour ces deux courbes, on voit que la dérive est non nulle sur une large gamme de températures notamment entre -20 et 80°C. Cette dérive fréquentielle est principalement liée à la variation du module d'Young en fonction de la température. Cependant, même faible entre 10 et 40°C, la dérive fréquentielle des deux exemples de fabrication actuelle peut nécessiter une correction extrinsèque au résonateur. C'est le cas par exemple d'une montre électronique qui contient un diapason en quartz corrigé électroniquement sur la base d'une mesure de la température de la montre, afin d'être certifiée COSC.

Ainsi, avantageusement, le but de l'invention est de proposer un résonateur dont la dérive fréquentielle en fonction de la température est encore minimisée comme montré par la courbe en traits interrompus courts et longs intitulé « composite » dont l'échelle est volontairement gardée identique par rapport aux deux autres courbes afin de montrer l'importante différence de la dérive. Plus précisément, le corps du résonateur, selon l'invention, comporte autant de revêtements que d'ordres du coefficient thermique à compenser.

Préférentiellement, le corps du résonateur comprend ainsi au moins deux revêtements et éventuellement un troisième si la compensation au deuxième ordre induit toujours une dérive fréquentielle inacceptable. Cependant, à partir du troisième ordre compensé, la dérive fréquentielle devient négligeable pour n'importe quel résonateur. Ainsi, suivant les grandeurs et les signes de chaque ordre des matériaux de l'âme et de chaque revêtement, un calcul de chaque épaisseur est effectué afin de compenser globalement chaque ordre.

A titre de définition, la variation relative de la fréquence du résonateur suit la relation suivante :

$$\frac{\Delta f}{f_0} = A + \alpha \cdot (T - T_0) + \beta \cdot (T - T_0)^2 + \gamma \cdot (T - T_0)^3$$

où

- $\dfrac{\Delta f}{f_0}$ est la variation relative de fréquence, exprimée en ppm (10-6) ;

- A une constante qui dépend du point de référence, en ppm ;

- $T_0$ la température de référence, en °C ;
- $\alpha$ le coefficient thermique du premier ordre, exprimé en ppm.°C$^{-1}$;
- $\beta$ le coefficient thermique du deuxième ordre, exprimé en ppm.°C$^{-2}$ ;
- $\gamma$le coefficient thermique du troisième ordre, exprimé en ppm.°C$^{-3}$.

De plus, le coefficient thermoélastique (CTE) représente la variation relative du module d'Young en fonction de la température. Les termes « $\alpha$ » et « $\beta$ » qui sont utilisés ci-dessous représentent ainsi respectivement les coefficients thermiques du premier et du deuxième ordre c'est-à-dire la variation relative de la fréquence du résonateur en fonction de la température. Les termes « $\alpha$ » et « $\beta$ » dépendent du coefficient thermoélastique du corps du résonateur et des coefficients de dilatation du corps. De plus, les termes « $\alpha$ » et « $\beta$ » prennent également en compte les coefficients propres à une éventuelle inertie séparée, telle que, par exemple, le balancier pour un résonateur balancier - spiral. Les oscillations de tout résonateur destiné à une base de temps ou de fréquence devant être entretenu, la dépendance thermique comprend également une contribution éventuelle du système d'entretien. Préférentiellement, le corps du résonateur est une âme 3 recouverte d'au moins deux revêtements 4, 5.

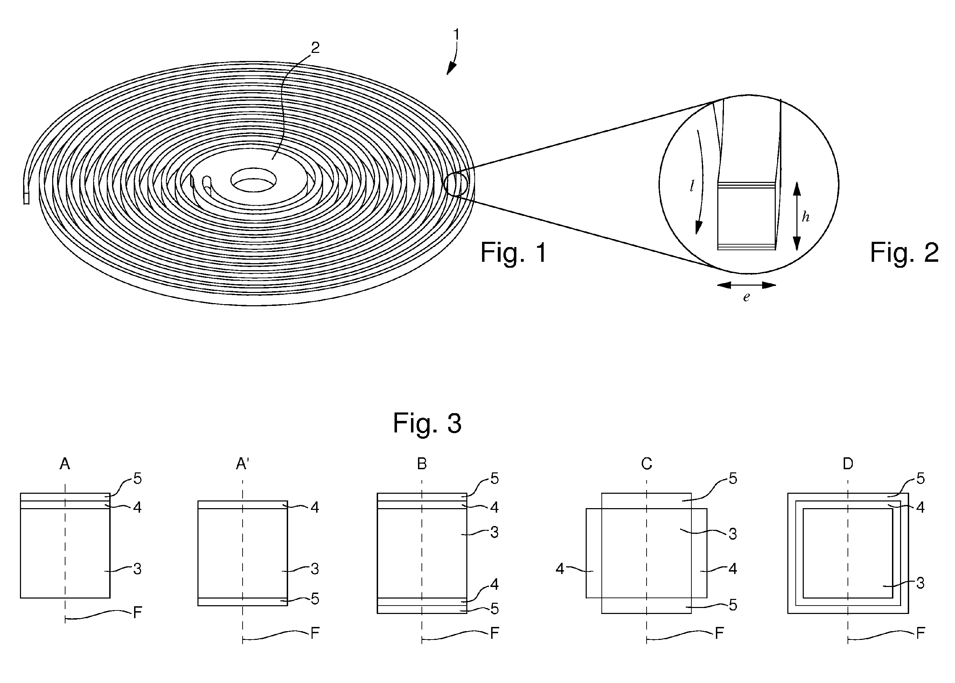

Dans l'exemple illustré aux figures 1 à 3, on peut voir un spiral 1 venu de forme avec sa virole 2 dont au moins les premier et deuxième ordres du coefficient thermoélastique du corps sont compensés. La figure 2 propose une coupe du corps du spiral permettant de mieux voir sa section en forme de quadrilatère. Le corps peut ainsi être défini par sa longueur *l*, sa hauteur *h* et son épaisseur *e*. La figure 3 montre des alternatives possibles A, A', B, C et D sans être exhaustives. Bien évidemment, les revêtements 4 et 5 ne sont pas à l'échelle par rapport aux dimensions de l'âme 3, ceci afin de mieux montrer les localisations de chaque partie 3, 4 et 5.

Dans une première alternative A, une seule face de la section est recouverte successivement par le revêtement 4 puis par le revêtement 5. L'ordre d'empilement entre les revêtements 4 et 5 n'est pas fixé, c'est-à-dire que les revêtements 4 et 5 peuvent être intervertis. De plus, quand ce sont les faces parallèles au plan neutre F du barreau qui sont recouvertes cela modifie avec plus d'intensité la fréquence dudit résonateur que si le dépôt était effectué sur celles perpendiculaires au plan de flexion F. Bien entendu, il peut également être imaginé que chaque revêtement 4, 5 soit présent sur une face différente comme illustré à l'alternative A'.

Dans une deuxième alternative B ou C, la section du corps comporte des faces identiques deux à deux. Ainsi soit deux faces parallèles comportent les deux revêtements 4, 5 empilés sans ordre particulier, c'est-à-dire que les revêtements 4 et 5 peuvent être intervertis, comme dans l'exemple B, soit chacune des faces parallèles possèdent un des revêtements 4, 5 comme dans l'exemple C. Bien entendu, il peut également être imaginé qu'un revêtement 4 soit présent sur deux faces adjacentes et que les deux autres faces soient recouvertes par un revêtement 5.

Dans une troisième alternative D, la section du barreau comporte des faces qui sont entièrement revêtues successivement par le revêtement 4 puis par le revêtement 5. L'ordre d'empilement entre les revêtements 4 et 5 n'a cependant ici pas non plus d'importance, c'est-à-dire que les revêtements 4 et 5 peuvent être intervertis.

Comme illustré à la figure 4, on peut voir un graphique représentant la dépendance thermique du module de Young de chaque matériau pour illustrer un mode de réalisation de l'invention qui utilise le silicium, le dioxyde de silicium et le dioxyde de germanium. Ainsi, le module d'Young du silicium diminue en augmentant la température quand les modules d'Young des deux autres matériaux croissent en augmentant la température. De plus, la croissance est plus marquée pour le dioxyde de silicium que pour le dioxyde de germanium entre les deux valeurs de température, c'est-à-dire entre -20°C et 80°C.

En fait, le coefficient thermoélastique du silicium est négatif au premier et second ordre quand les coefficients thermoélastiques des deux autres matériaux sont positifs au premier ordre. Cependant, le coefficient thermoélastique au deuxième ordre est négatif pour le dioxyde de silicium alors qu'il est positif pour le dioxyde de germanium.

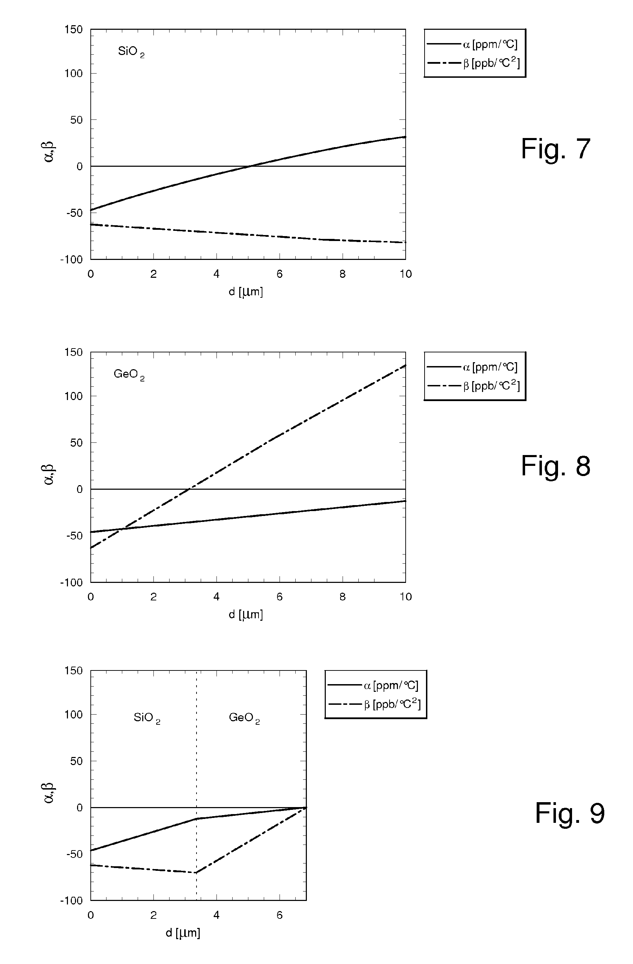

Cependant, cette interprétation de la figure 4 se focalise sur le coefficient thermoélastique des matériaux. Il est nécessaire de prendre encore en compte les coefficients de dilatations des matériaux et l'effet du système d'entretien des oscillations pour finalement obtenir les coefficients $\alpha$, $\beta$ de la modification de la fréquence du résonateur. Pour comprendre cette interprétation finale, ses deux coefficients sont représentés aux figures 7 et 8.

Ainsi, pour la figure 7, l'âme 3 comporte des coefficients thermoélastiques des premier et deuxième ordres qui sont négatifs, comme le silicium, et recouvert par un revêtement 4 qui comporte les coefficients thermoélastiques du premier ordre positif et du deuxième ordre négatif, comme le dioxyde de silicium. Sont également pris en compte, les coefficients de dilatation des matériaux, en particulier celui du balancier (18 ppm/°C). L'effet du système d'entretien des oscillations est ici négligé. On peut également voir à la figure 7 que les ordres $\alpha$ (trait continu) et $\beta$ (traits discontinus) ne sont pas à la même unité. On voit qu'à partir d'une certaine épaisseur de revêtement, le premier ordre $\alpha$ est compensé, c'est-à-dire croise la ligne 0, par contre, le deuxième ordre $\beta$ ne fait que diminuer par rapport au matériau de l'âme seul. On comprend donc que si le premier ordre $\alpha$ peut être compensé, tel n'est pas le cas du deuxième ordre $\beta$.

A la figure 8, l'âme 3 comporte des coefficients thermoélastiques des premier et deuxième ordres qui sont négatifs, comme le silicium, et recouvert par un revêtement 5 qui comporte des coefficients thermoélastiques des premier et deuxième ordres qui sont positifs, comme le dioxyde de germanium. Comme pour la figure 7, on peut voir à la figure 8 que les ordres $\alpha$ (trait continu) et $\beta$ (traits discontinus) ne sont pas à la même unité. On voit qu'à partir d'une faible épaisseur de revêtement, le deuxième ordre $\beta$ est compensé, c'est-à-dire croise la ligne 0, par contre, le premier ordre $\alpha$ est compensé à une plus forte épaisseur. Cependant, il est impossible que les deux ordres $\alpha$ et $\beta$ soient compensés avec une épaisseur d'un seul matériau.

Cela est dû aux différences de grandeurs des coefficients thermoélastiques à chaque ordre de chaque matériau. Ainsi, s'il semble illusoire de trouver un matériau pour le revêtement exactement « inverse » à celui de l'âme, ce qui permettrait de déposer une couche unique de compensation, l'invention propose, pour chaque ordre à compenser, d'ajouter un revêtement. Chaque revêtement n'est alors pas destiné à corriger « directement » un ordre mais permet d'affiner chacune des compensations.

A titre d'exemple, des calculs ont été représentés à la figure 9. Dans cet exemple, l'âme 3 comporte des coefficients thermoélastiques des premier et deuxième ordres qui sont négatifs, comme le silicium. L'âme 3 est recouverte par un premier revêtement 4 qui comporte des coefficients thermoélastiques du premier ordre positif et du deuxième ordre négatif, comme le dioxyde de silicium. Le premier revêtement 4 est lui-même recouvert par un deuxième revêtement 5 qui comporte un coefficient thermoélastique des premier et deuxième ordres qui sont positifs, comme le dioxyde de germanium.

Comme visible à la figure 9, on voit qu'il devient possible par calcul d'ajuster chaque épaisseur de revêtement 4, 5 afin que la compensation des ordres $\alpha$ et $\beta$ convergent sensiblement à la même épaisseur finale, c'est-à-dire que les deux courbes $\alpha$ et $\beta$ coupent la ligne 0 à la même épaisseur. Dans notre exemple de la figure 9, l'âme 3, le premier revêtement 4 et le deuxième revêtement 5 comportent ainsi des épaisseurs respectives d'environ 40, 3,5 et 3,6 microns.

Ainsi, suivant l'épaisseur de l'âme 3 voulue ou celle de la section finale voulue, il est possible d'offrir un résonateur dont la compensation thermique est très améliorée par rapport à celles « Quartz-z-cut » ou « Si-SiO$_2$ » représentées à la figure 6.

Bien entendu, la présente invention ne se limite pas à l'exemple illustré mais est susceptible de diverses variantes et modifications qui apparaîtront à l'homme de l'art. En particulier, d'autres matériaux pour l'âme 3 ou pour les revêtements 4, 5, etc. sont envisageables en obtenant une compensation thermique améliorée.

A titre d'exemple, il est fort probable qu'un matériau qui sera appelé X (comme les oxydes de zirconium ou d'hafnium stabilisés), qui comporte des coefficients thermoélastiques du premier ordre négatif (comme c'est le cas de la plupart des matériaux) et du deuxième ordre positif, puisse réaliser la compensation thermique. Cet exemple est illustré à la figure 5. On comprend donc que, pour ce type de matériau, le premier revêtement a nécessairement une épaisseur supérieure par rapport à celle du mode de réalisation de la figure 4.

## Revendications

1. Résonateur (1) thermocompensé comportant un corps utilisé en déformation, l'âme (3) du corps comportant un premier matériau **caractérisé en ce que** le corps comporte au moins un premier et un deuxième revêtements (4, 5) permettant audit résonateur d'avoir des coefficients thermiques aux premier et deuxième ordres ($\alpha$, $\beta$) sensible-ment nuls.

2. Résonateur (1) selon la revendication précédente, **caractérisé en ce que** le corps comporte un troisième revêtement permettant audit résonateur d'avoir des coefficients thermiques aux premier, deuxième et troisième ordres ($\alpha$, $\beta$, $\gamma$ sensiblement nuls.

3. Résonateur (1) selon la revendication 1 ou 2, **caractérisé en ce que** l'âme (3) du corps comporte des coefficients thermoélastiques des premier et deuxième ordres qui sont négatifs.

4. Résonateur (1) selon la revendication précédente, **caractérisé en ce que** l'âme (3) du corps comporte du silicium monocristallin.

5. Résonateur (1) selon l'une des revendications précédentes, **caractérisé en ce que** le corps comporte une section sensiblement en forme d'un quadrilatère dont les faces sont identiques deux à deux.

6. Résonateur (1) selon l'une des revendications 1 à 4, **caractérisé en ce que** le corps comporte une section sensiblement en forme d'un quadrilatère dont les faces sont entièrement revêtues.

7. Résonateur (1) selon l'une des revendications précédentes, **caractérisé en ce que** le premier revêtement (4) comporte des coefficients thermoélastiques du premier ordre positif et du deuxième ordre négatif.

**8.** Résonateur (1) selon la revendication précédente, **caractérisé en ce que** le premier revêtement (4) comporte du dioxyde de silicium.

**9.** Résonateur (1) selon la revendication 7 ou 8, **caractérisé en ce que** le deuxième revêtement (5) comporte un coefficient thermoélastique du deuxième ordre positif.

**10.** Résonateur (1) selon la revendication précédente, **caractérisé en ce que** le deuxième revêtement (5) comporte un coefficient thermoélastique du premier ordre positif.

**11.** Résonateur (1) selon la revendication précédente, **caractérisé en ce que** le deuxième revêtement (5) comporte du dioxyde de germanium.

**12.** Résonateur (1) selon la revendication 9, **caractérisé en ce que** le deuxième revêtement (5) comporte un coefficient thermoélastique du premier ordre négatif.

**13.** Résonateur (1) selon l'une des revendications 9 à 12, **caractérisé en ce que** le premier revêtement (4) est interverti avec le deuxième revêtement (5).

**14.** Résonateur (1) selon l'une des revendications précédentes, **caractérisé en ce que** le dépôt desdits revêtements est privilégié sur les faces parallèles par rapport au plan neutre (F) du corps afin de modifier avec le plus d'intensité possible la fréquence dudit résonateur.

**15.** Résonateur (1) selon l'une des revendications précédentes, **caractérisé en ce que** le corps est un barreau enroulé sur lui-même en formant un spiral et est couplé avec un volant d'inertie.

**16.** Résonateur (1) selon l'une des revendications 1 à 14, **caractérisé en ce que** le corps comporte au moins deux barreaux montés symétriquement afin de former un diapason.

**17.** Résonateur (1) selon l'une des revendications 1 à 14, **caractérisé en ce que** le corps est un résonateur MEMS.

**18.** Pièce d'horlogerie **caractérisée en ce qu'**elle comporte au moins un résonateur conforme à l'une des revendications précédentes.

Fig. 1

Fig. 2

Fig. 3

EP 2 337 221 A1

Fig. 4

Fig. 5

Fig. 6

Fig. 7

Fig. 8

Fig. 9

Europäisches
Patentamt

European
Patent Office

Office européen
des brevets

# RAPPORT DE RECHERCHE EUROPEENNE

Numéro de la demande

EP 09 17 9323

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2005/195050 A1 (LUTZ MARKUS [US] ET AL) 8 septembre 2005 (2005-09-08) * alinéa [0120] - alinéa [0122]; figures 12A,12B,12C,12D * * alinéa [0161] - alinéa [0163] * ----- | 1-18 | INV. H03H9/02 G04B17/06 G04B17/22 |
| X | WO 2007/072409 A2 (NXP BV [NL]; VAN BEEK JOZEF T M [NL]; LOEBL HANS-PETER [DE]; VANHELMON) 28 juin 2007 (2007-06-28) * abrégé * * page 6, ligne 16 - page 11, ligne 19; figures 1-3 * ----- | 1-18 | |
| X | NAKAGAWA Y: "Control of second order temperature coefficient of SAW propagating in two thin film layers" ULTRASONICS SYMPOSIUM, 1993. PROCEEDINGS., IEEE 1993 BALTIMORE, MD, USA 31 OCT.-3 NOV. 1993, NEW YORK, NY, USA,IEEE LNKD-DOI:10.1109/ULTSYM.1993.339570, 31 octobre 1993 (1993-10-31), pages 287-290, XP010115030 ISBN: 978-0-7803-1278-4 * le document en entier * ----- | 1-18 | DOMAINES TECHNIQUES RECHERCHES (IPC) H03H G04B B81B |
| A | SCHOEN F ET AL: "Temperature Compensation in Silicon-Based Micro-Electromechanical Resonators" MICRO ELECTRO MECHANICAL SYSTEMS, 2009. MEMS 2009. IEEE 22ND INTERNATIONAL CONFERENCE ON, IEEE, PISCATAWAY, NJ, USA, 25 janvier 2009 (2009-01-25), pages 884-887, XP031444436 ISBN: 978-1-4244-2977-6 * le document en entier * ----- | 1-18 | |

-/--

Le présent rapport a été établi pour toutes les revendications

| Lieu de la recherche | Date d'achèvement de la recherche | Examinateur |
|---|---|---|
| Munich | 17 juin 2010 | Trafidlo, Renata |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 09 17 9323

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | EP 1 422 436 A1 (CSEMCT SUISSE D ELECTRONIQUE E [CH] SUISSE ELECTRONIQUE MICROTECH [CH]) 26 mai 2004 (2004-05-26) * abrégé * * alinéa [0016] - alinéa [0038]; figures 1-3 * ----- | 1-18 | |
| A,D | WO 2008/043727 A1 (SUISSE ELECTRONIQUE MICROTECH [CH]; BABOROWSKI JACEK [CH]; BOURGEOIS C) 17 avril 2008 (2008-04-17) * abrégé * * alinéa [0011] - alinéa [0040]; figure 1 * ----- | 1-18 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 17 juin 2010 | Trafidlo, Renata |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P04C02)

**EP 2 337 221 A1**

**ANNEXE AU RAPPORT DE RECHERCHE EUROPEENNE
RELATIF A LA DEMANDE DE BREVET EUROPEEN NO.**   EP 09 17 9323

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-06-2010

| Document brevet cité au rapport de recherche | Date de publication | Membre(s) de la famille de brevet(s) | Date de publication |
|---|---|---|---|
| US 2005195050 A1 | 08-09-2005 | CN 1951009 A | 18-04-2007 |
| | | EP 1723720 A1 | 22-11-2006 |
| | | US 2006033594 A1 | 16-02-2006 |
| | | WO 2005096495 A1 | 13-10-2005 |
| WO 2007072409 A2 | 28-06-2007 | CN 101346879 A | 14-01-2009 |
| | | EP 1974465 A2 | 01-10-2008 |
| | | JP 2009521176 T | 28-05-2009 |
| | | US 2009219104 A1 | 03-09-2009 |
| | | US 2009121808 A1 | 14-05-2009 |
| EP 1422436 A1 | 26-05-2004 | AT 307990 T | 15-11-2005 |
| | | AU 2003271504 A1 | 18-06-2004 |
| | | WO 2004048800 A1 | 10-06-2004 |
| | | CN 1717552 A | 04-01-2006 |
| | | DE 60206939 D1 | 01-12-2005 |
| | | DE 60206939 T2 | 27-07-2006 |
| | | HK 1067687 A1 | 19-05-2006 |
| | | JP 2006507454 T | 02-03-2006 |
| | | US 2005281137 A1 | 22-12-2005 |
| WO 2008043727 A1 | 17-04-2008 | EP 2074695 A1 | 01-07-2009 |
| | | US 2010013360 A1 | 21-01-2010 |

**RÉFÉRENCES CITÉES DANS LA DESCRIPTION**

**Documents brevets cités dans la description**

- EP 1422436 A

- WO 2008043727 A